(19) Europäisches Patentamt
European Patent Office
Office européen des brevets

(11) **EP 2 009 709 B1**

(12) **EUROPÄISCHE PATENTSCHRIFT**

(45) Veröffentlichungstag und Bekanntmachung des Hinweises auf die Patenterteilung:
**26.11.2014 Patentblatt 2014/48**

(21) Anmeldenummer: **08011099.2**

(22) Anmeldetag: **19.06.2008**

(51) Int Cl.:
*H01L 35/08* (2006.01)      *H01L 35/32* (2006.01)
*H01L 31/04* (2014.01)

(54) **Thermoelektrisches Element**

Thermo-electric element

Elément thermoélectrique

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **29.06.2007 AT 10092007**

(43) Veröffentlichungstag der Anmeldung:
**31.12.2008 Patentblatt 2009/01**

(73) Patentinhaber: **Span, Gerhard**
**6112 Wattens (AT)**

(72) Erfinder: **Span, Gerhard**
**6112 Wattens (AT)**

(74) Vertreter: **Gangl, Markus et al**
**Torggler & Hofinger**
**Patentanwälte**
**Wilhelm-Greil-Straße 16**
**6020 Innsbruck (AT)**

(56) Entgegenhaltungen:
DE-A1- 3 835 279      JP-A- 4 280 482
JP-A- 50 116 192      JP-A- 57 115 877
JP-A- 2003 069 088    US-A- 3 956 017
US-A- 4 500 741       US-A- 6 084 175
US-A- 6 107 645       US-A1- 2006 237 730
US-A1- 2008 053 514

**Beschreibung**

Die vorliegende Erfindung betrifft einen thermoelektrischen Generator mit einem thermoelektrischen Element mit wenigstens einem Thermopaar und einem pn-Übergang, wobei das Thermopaar ein erstes Material mit einem positiven Seebeck-Koeffizienten und ein zweites Material mit einem negativen Seebeck-Koeffizienten aufweist.

Der Stand der Technik gliedert sich in verschiedene Bereiche, die unterschiedliche Entwicklungsstufen zeigen.

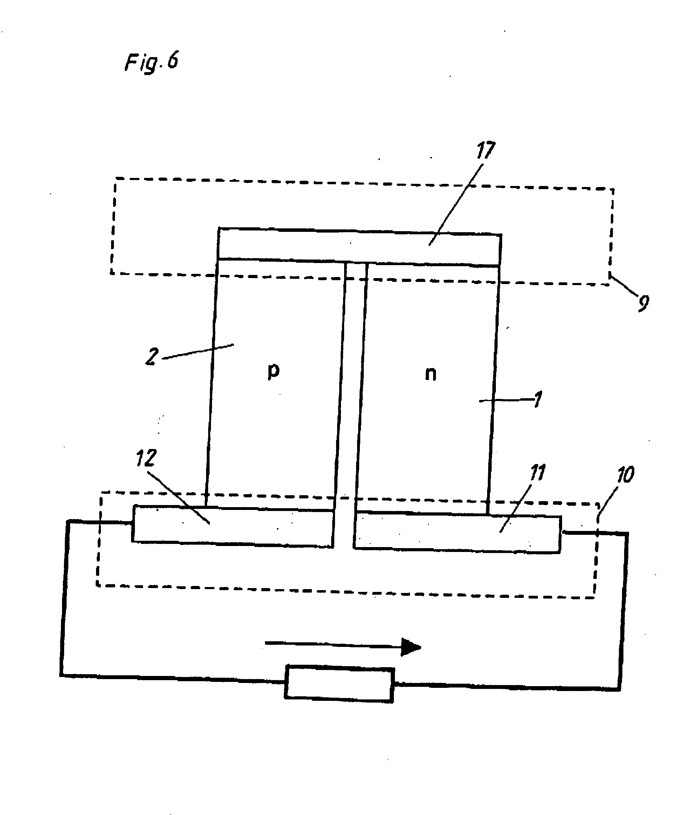

Der thermoelektrische Effekt ist bereits seit mehr als 100 Jahren bekannt. Es gibt ein breites Spektrum an Materialien, die für die direkte Umwandlung einer Temperaturdifferenz in elektrischen Strom (thermoelektrischer Generator) oder für die Kühlung bei Anlegen einer externen Spannungsquelle (thermoelektrischer Kühler) verwendet werden können. Die technische Umsetzung des Generatoreffektes basierte bisher immer auf einem gemeinsamen grundsätzlichen Aufbau (Fig. 6). Zwei, unterschiedliche Metalle oder zwei unterschiedlich (n- und p-) dotierte Halbleiter werden an einem, im Normalfall dem heißen Ende über einen metallischen Leiter verbunden, und am anderen, normalerweise kalten Ende kann dann der Strom abgegriffen werden. Die Energie zur Überwindung der Unterschiede im elektrostatischen Potential zwischen den Materialien an den Kontaktstellen wird aus der Umgebungswärme bezogen (Peltiereffekt).

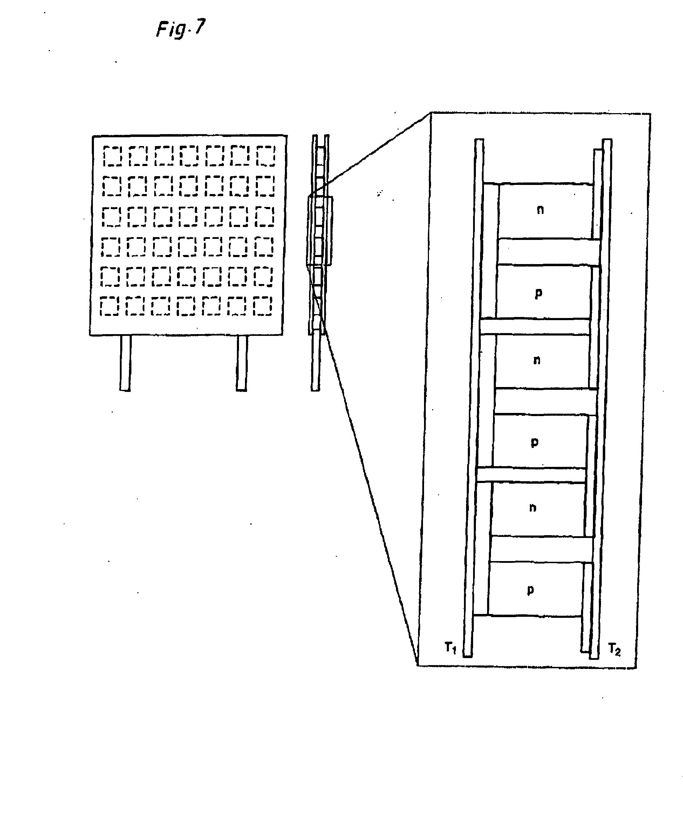

Um eine möglichst effektive Umwandlung des Temperaturgradienten in elektrischen Strom zu erhalten, werden die thermoelektrischen Elemente so zu einem Modul zusammen gebaut, dass die einzelnen Elemente elektrisch in Serie, aber thermisch parallel geschaltet sind. Diese Module lassen sich wiederum zu größeren Einheiten zusammenfassen (Fig. 7). Eine derartige Vorrichtung geht beispielsweise aus der EP 339 715 A1 hervor.

Die Auswahl der verwendeten Materialien erfolgt nach dem Gesichtspunkt des maximal möglichen Wirkungsgrades im angestrebten Temperaturbereich. Der Wirkungsgrad wird im allgemeinen durch die *figure of merit* $Z = S^2/\rho\kappa$ charakterisiert (S ... Seebeck-Koeffizient oder absolute differentielle Thermokraft, $\rho$... spezifischer Widerstand, $\kappa$ ... Wärmeleitfähigkeit). Ein hoher Wirkungsgrad wird in einem Material mit hohem Seebeck-Koeffizient bei gleichzeitigem niedrigen spezifischen Widerstand und niedriger Wärmeleitfähigkeit erreicht.

Die thermoelektrischen Elemente basierend auf Paaren von n- und p-Typ Materialblöcken sind die dabei am weitesten entwickelt, haben aber auch nach mehr als 50 Jahren Entwicklungszeit kaum Fortschritte aufzuweisen. Diese thermoelektrischen Elemente sind seit Jahrzehnten als Produkt erhältlich und werden vor allem zur Kühlung verwendet (thermoelektrischer Kühler, Peltiermodule).

Der wesentliche Vorteil dieses Standes der Technik ist, dass die Herstellungsverfahren seit Jahrzehnten bekannt und ausgereift sind.

Nachteile:

Die für die Thermoelektrizität wichtigen Eigenschaften eines Materials (S ... Seebeck-Koeffizient, $\rho$.. spezifischer Widerstand, $\kappa$ ... Wärmeleitfähigkeit) lassen sich nur in sehr geringem Maße voneinander unabhängig beeinflussen. Dieser Zusammenhang begrenzt die derzeit realisierbaren Wirkungsgrade auf ca. 10 - 20% der Carnot-Effizienz.

Der Verlauf des Temperaturgradienten hat keinen Einfluss auf den Wirkungsgrad, da in konventionellen thermoelektrischen Elementen aufgrund des linearen Zusammenhangs zwischen Thermokraft und Temperaturdifferenz nur die Gesamtdifferenz der Temperaturen zwischen heißer und kalter Seite eine Rolle spielt.

Die Leistungsdichte ist zu gering, um größere Leistungen technisch und wirtschaftlich sinnvoll umsetzen zu können.

Ein weiterer, vielversprechender Entwicklungszweig im Grenzbereich von Thermoelektrizität und Thermoionischen Effekt wird von der Firma Eneco, Inc. in Salt Lake City, Utah, USA (Yan R. Kucherov und Peter L. Hagelstein) mit der Entwicklung eines thermoionischen Konverters und einer thermischen Diode begangen.

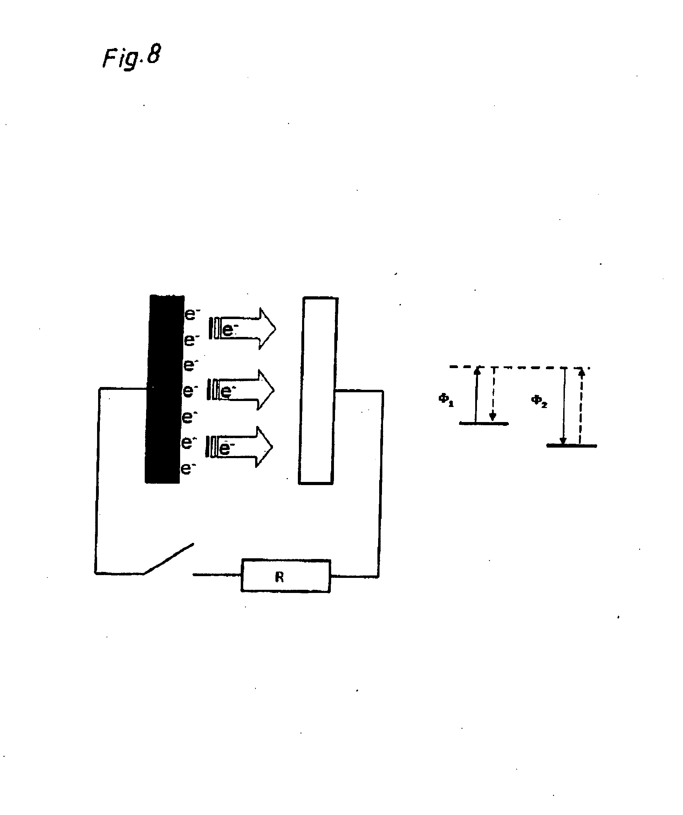

Ein thermoionischer Konverter (Fig. 8) besteht aus einer erwärmten Metallplatte und einer gekühlten Metallplatte, getrennt durch ein Vakuum und einen externen Stromkreis. Durch die höhere Temperatur in der erwärmten Metallplatte haben dort mehr Elektronen genügend Energie, die Potentialbarriere in Richtung der Metallplatte zu überwinden als in umgekehrter Richtung. Damit kann Strom aus einer Temperaturdifferenz gewonnen werden. Aufgrund der hohen Potentialbarriere findet dieser Prozess allerdings nur bei sehr hohen Temperaturen statt.

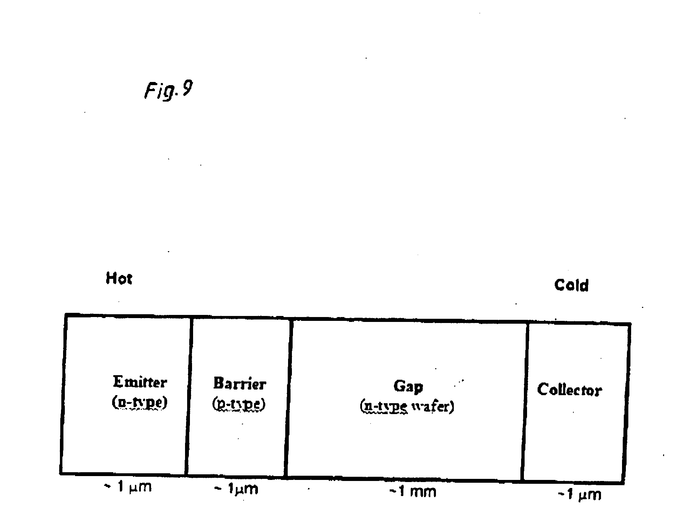

Thermische Dioden haben dieselben funktionellen Komponenten, allerdings wird das Vakuum durch einen Halbleiter ersetzt. Ein schematischer Aufbau einer n-Typ thermischen Diode von Eneco, Inc. wird in Fig. 9 gezeigt. Der Halbleiter anstelle des Vakuums sorgt für eine niedrigere Potentialbarriere, daher funktioniert die thermische Diode auch bei niedrigeren Temperaturen.

Bei richtiger Anordnung von weiteren Potentialbarrieren zwischen Kollektor und Gap-Halbleiter wird verhindert, dass Elektronen wieder zurückfließen. Damit werden Elektronen akkumuliert und eine höhere Arbeitsspannung kann erreicht werden.

Vorteile dieses Standes der Technik:

Der Wirkungsgrad der Umwandlung von Wärme in Strom ist höher.

Im Gegensatz zu gattungsgemäßen thermoelektrischen Elementen können thermische Dioden in Serie geschaltet werden, ohne dass die Effizienz darunter leidet. Damit ist es einfacher, die maximale theoretische Effizienz zu erreichen.

Nachteile dieses Standes der Technik:

Dieser Aufbau funktioniert nur mit Elektronen, für Löcher gibt es keine thermische Diode, daher muss der Stromkreis über einen elektrischen Leiter geschlossen werden, über den auch Wärme fließt und damit den Wirkungsgrad erniedrigt.

Der genutzte Effekt kommt nur zustande, wenn die Dicken der Barrieren im Bereich der Streulängen und damit bei einigen 100 Nanometern sind (beim verwendeten InSb 1.5 Mikrometer). Bei höheren Temperaturen ist die Diffusion von Materialien stärker, daher werden die Potentialbarrieren mit der Zeit verrundet und die für die Aufrechterhaltung des Effektes notwendigen Längen werden nicht mehr eingehalten. Deshalb sind die zur Stromerzeugung nutzbaren Temperaturen nach oben stark begrenzt.

Um die Generation von Elektron-Loch Paaren auszunutzen, kann bei bekannten thermoelektrischen Elementen ein pn-Übergang mit Temperaturgradient ausgenutzt werden (AT 410 492 B).

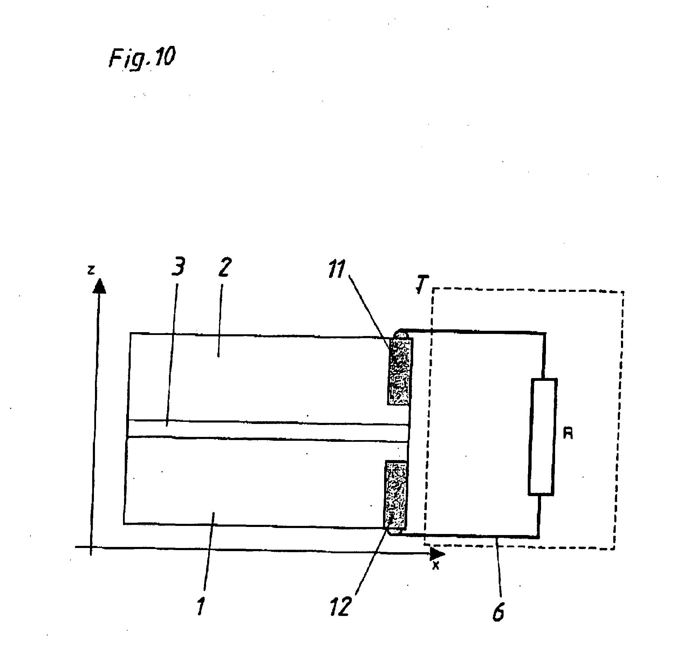

In dem in Fig. 10 gezeigten Aufbau werden Elektron-Loch Paare am heissen Ende erzeugt, da durch die Ladungsträgerdrift aufgrund des Temperaturgradienten das thermische Gleichgewicht zwischen Generation und Rekombination zugunsten der Generation verschoben ist. Der pn-Übergang ist hier ein Teil der Gesamtstruktur, der baulich nicht vom Ort des Temperaturgradienten getrennt sein kann.

Vorteile dieses Standes der Technik:

Die Betriebstemperaturen können je nach Material extrem hoch sein.

Einfacher Aufbau ähnlich einer Solarzelle

Nachteile dieses Standes der Technik:

Die Rekombination von Ladungsträgern lässt sich nicht gänzlich verhindern, wodurch der Wirkungsgrad verkleinert wird.

Für den Transport der Landungsträger sind dicke Schichten notwendig, die anspruchsvollere Herstellungsmethoden notwendig machen.

Die DE 101 36 667 A1 zeigt die Integration einer Diode in einen Schenkel eines Peltierelements.

Aus der der GB 953 339 A1 geht die bauliche Vereinigung eines Peltierelements mit einer Diode hervor.

Aufgabe der Erfindung ist es, einen verbesserten thermoelektrischen Generator zu schaffen.

Diese Aufgabe wird durch einen thermoelektrischen Generator mit den Merkmalen des Anspruchs 1 gelöst.

Die grundlegend neue Idee besteht darin, einen pn-Übergang (zum Beispiel einer Diode) als Generationszentrum von Elektronen und Löchern als Erweiterung eines bekannten Thermopaares zu verwenden.

Ohne die Erzeugung von Elektron-Loch-Paaren wirkt ein Thermopaar nur als Ladungsträgerpumpe, deren Eigenschaften durch die Wahl eines Materials bestimmt sind. Die Abmessungen oder andere äußere Eigenschaften haben nur einen begrenzten Einfluss. Durch die Erzeugung von neuen Elektron-Loch Paaren werden diese Grenzen umgangen und deutlich höhere Effizienzen möglich.

Beim Einsatz des erfindungsgemäßen thermoelektrischen Elements in einem thermoelektrischen Generator mit den Merkmalen des Anspruchs 1 besteht der Erfindungsgedanke darin, dass die durch einen Temperaturunterschied hervorgerufene Thermospannung eines Thermopaares dazu genutzt wird, einen mit der heißen Seite elektrisch verbundenen pn-Übergang in Rückwärtsrichtung (Sperrrichtung) vorzuspannen. In diesem pn-Übergang werden durch thermische Anregung Elektron-Loch Paare erzeugt. Das Ausmaß dieser thermischen Anregung hängt von der Temperatur, der Bandlücke und der Anzahl von Generationszentren ab:

$$I_{elektrisch} \approx G \approx N_t \exp\left(-\frac{E_t - E_i}{kT}\right)$$

In einem pn-Übergang mit Vorspannung in Sperrrichtung fließt Strom aufgrund der Generation von Elektron-Loch Paaren, die durch das eingebaute elektrische Feld sofort getrennt werden und daher als Nettostrom in Erscheinung treten.

Vorteile der Erfindung:

Durch die Generation von Elektron-Loch Paaren können mehr Ladungsträger erzeugt werden, als durch die Dotierung vorgegeben sind. Damit ist eine höhere Leistungsdichte und Effizienz erreichbar.

Die Generation von Elektron-Loch Paaren ist räumlich vom Ort der Entstehung der Thermospannung getrennt und kann daher durch die Materialwahl oder einen anderen Herstellungsprozess unabhängig von der Wärmeleitung optimiert werden. Es ist auch kein Temperaturgradient notwendig.

Durch die Verwendung von einem Material mit niedrigerer Bandlücke im Vergleich mit dem Thermopaar kann sowohl der Transport als auch die Erzeugung der Ladungsträger optimiert werden.

Weitere vorteilhafte Ausführungsformen der Erfindung sind in den abhängigen Ansprüchen definiert.

Der das erste Material selektiv mit der p-Seite des pn-Übergangs kontaktierende Leiter und der das zweite Material selektiv mit der n-Seite des pn-Übergangs kontaktierende Leiter können zum Beispiel metal-

Das Thermopaar und die Diode können räumlich getrennt voneinander nur durch einen elektrischen Leiter verbunden sein. Auch können das Thermopaar und die Diode aus verschiedenen Materialien sein, um die Generation von Ladungsträgern und den Transport derselben getrennt voneinander optimieren zu können. Für die thermische Generation sind sowohl die Anzahl an Generationszentren als auch das Verhältnis von thermischer Energie (Temperatur) und Energielücke ausschlaggebend. Der Transport der Ladungsträger im Thermopaar ist separat zu optimieren, z.B. durch Nutzung unterschiedlicher Materialien, Herstellungsmethoden und Materialstrukturen (Nanotechnologie zur Modulation der Wärmeleitfähigkeit durch Übergitter, Quantenpunkte, etc.).

Für die Optimierung des Stromes und damit der Ladungsträgergeneration sind die intrinsische Konzentration $n_I$ (damit die Temperatur und Bandlücke) und die Generationslebensdauer $\tau_g$ (damit die Anzahl an Generationszentren, der Wirkungsquerschnitt und die Temperatur) die bestimmenden physikalischen Größen:

$$I \approx G = \frac{n_i}{\tau_g} 5$$

$$n_i = \sqrt{N_C \cdot N_V} \cdot e^{\left(-\frac{\varepsilon_g}{2kT}\right)}$$

$$\tau_g = \frac{2 \cosh\left(\frac{E_T - E_i}{kT}\right)}{\nu_{th} \sigma_0 N_T}$$

Für die Erfindung sind dieselben physikalischen Parameter wie beim Stand der Technik von Bedeutung. Allerdings können mit der Erfindung die Abhängigkeiten der Parameter untereinander aufgeweicht werden, da die laterale Änderung der Parameter einen Einfluss auf den Wirkungsgrad der Gesamtstruktur hat.

Zusätzlich eröffnet die Erfindung eine Fülle von neuen Kandidaten für gute thermoelektrische Materialien.

Die bevorzugten Materialien für die Ausübung der Erfindung sind Halbleiter, wobei der genutzte Temperaturbereich die Auswahl der Materialien bestimmt.

Verbindungshalbleiter sind aufgrund der niedrigen Wärmeleitfähigkeit die bevorzugten Materialien für thermoelektrische Module. Einige Beispiele für gute thermoelektrische Materialien sind: $Bi_2Te_3$, $PbTe$, $SiGe$, Clathrate (Klathrate) und Materialien mit Perovskitstrutur und halbleitende Polymere.

Für den Aufbau des pn-Übergangs können die Materialien ohne Rücksicht auf eine niedrige Wärmeleitfähigkeit genutzt werden, da kein Temperaturgradient notwendig ist.

Es sind hohe bis sehr hohe Dotierungen bevorzugt, um den spezifischen Widerstand möglichst gering zu halten. Die Werte für die Dotierungen sind natürlich abhängig vom Material. Als Beispiel: bei $PbTe$ sind Dotierungen von $10^{18} cm^{-3}$ und höher notwendig.

Anwendung der Erfindung :

Thermoelektrische Generatoren zur direkten Umwandlung einer Temperaturdifferenz in Strom. Mit diesem Konzept kann eine eventuell anfallende Restwärme, die ansonsten ungenutzt bliebe, genutzt werden.

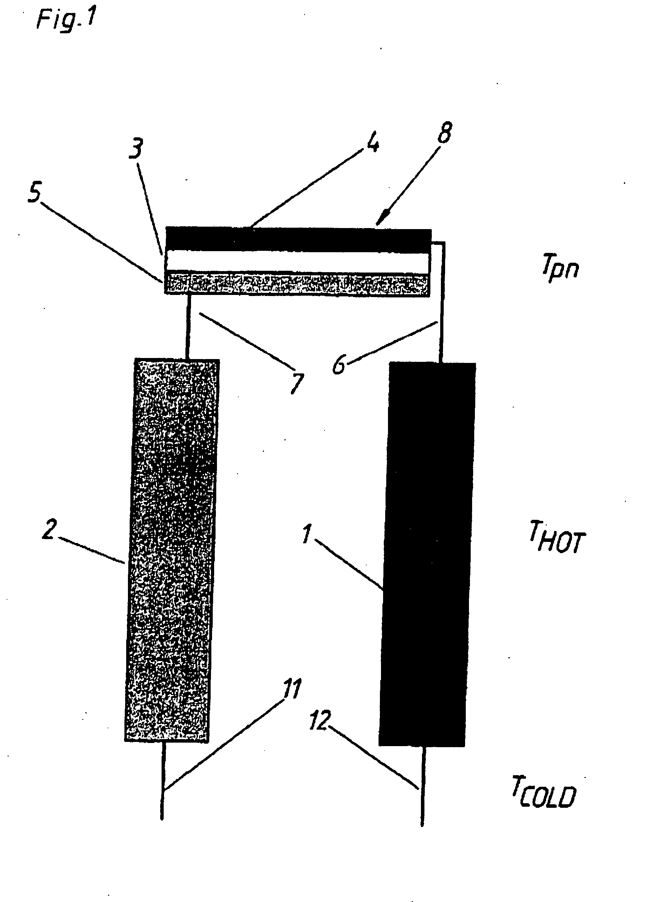

Weitere Einzelheiten und Vorteile der Erfindung ergeben sich anhand der Figuren 1 bis 5 sowie der dazugehörigen Figurenbeschreibung. Der Stand der Technik ist zum besseren Verständnis der Erfindung in den Figuren 6 bis 10 dargestellt.

Fig. 1 zeigt ein thermoelektrisches Element mit einem Thermopaar, welches ein erstes Material 1 mit einem positiven Seebeck Koeffizienten und ein zweites Material 2 mit einem negativen Seebeck Koeffizienten aufweist. Weiters ist in einer Diode 8 ein pn-Übergang 3 ausgebildet. Das erste Material 1 ist über einen elektrischen Leiter 6 selektiv mit der p-Seite 4 des pn-Übergangs 3 kontaktiert. Das zweite Material 2 ist über den elektrischen Leiter 7 selektiv mit der n-Seite 5 des pn-Übergangs 3 kontaktiert.

Werden an die Kontakte 11, 12 die Pole einer nicht dargestellten externen Spannungsquelle angeschlossen, so arbeitet das dargestellte thermoelektrische Element als thermoelektrischer Kühler. In diesem Fall wird der pn-Übergang 3 durch die externe Spannungsquelle bei einer der beiden möglichen Polungen elektrisch in Sperrrichtung gepolt. Das eine Ende ($T_{cold}$) der Materialien 1, 2 kühlt dabei ab. Das andere Ende ($T_{hot}$) der Materialien 1, 2 erwärmt sich.

Wird hingegen das thermoelektrische Element als thermoelektrischer Generator eingesetzt, so wird das eine Ende ($T_{cold}$) der Materialien 1, 2 mit einer nicht dargestellten Wärmesenke kontaktiert, während das andere Ende ($T_{hot}$) der Materialien 1, 2 mit einer Wärmequelle kontaktiert wird. Hierdurch ergibt sich in den jeweiligen Materialien 1, 2 eine elektrische Spannung (im ersten Material 1 lädt sich die dem elektrischen Leiter 6 zugewandte Seite negativ auf; im zweiten Material 2 lädt sich die dem elektrischen Leiter 7 zugewandte Seite positiv auf). Hierdurch wird der pn-Übergang 3 in Sperrrichtung geschalten. Das im pn-Übergang 3 realisierte elektrische Feld trennt dabei generierte Elektron-Loch-Paare räumlich, welche daher als Nettostrom in Erscheinung treten können. Eine Spannung kann über die Kontakte 11, 12 abgegriffen werden, wobei der Kontakt 11 der negative Pol und der Kontakt 12 der positive Pol ist.

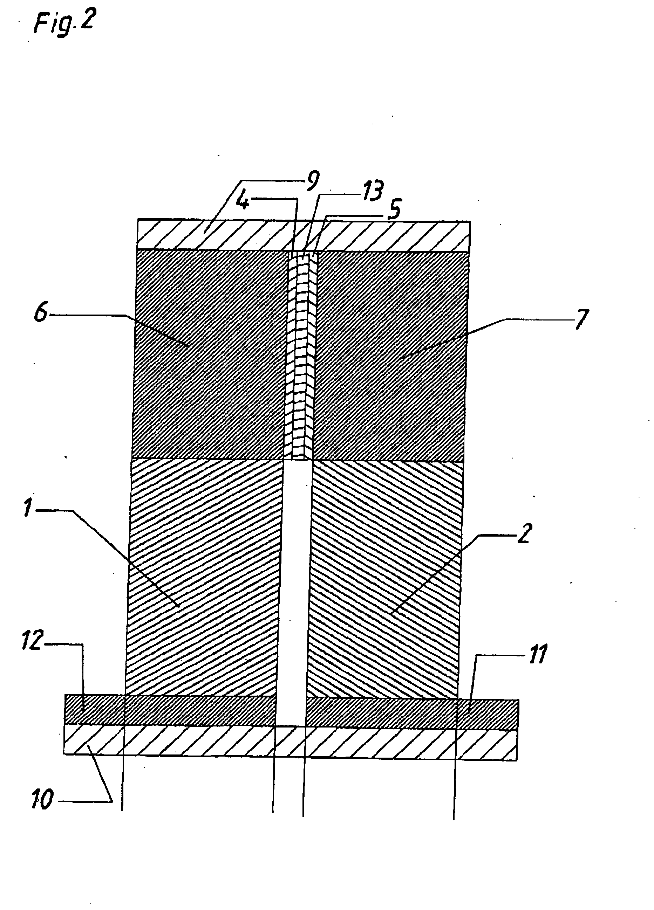

Ein weiteres Ausführungsbeispiel der Erfindung ist in Fig. 2 dargestellt. Der pn-Übergang 3 ist in diesem Ausführungsbeispiel in einer Zwischenschicht 13 ausgebildet. Der pn-Übergang 3 sowie das erste Material 1 und das zweite Material 2 (hier p- bzw. n-dotierte Halbleiter) stehen dabei mit einer Wärmequelle 9 in thermischer Verbindung. Das erste Material 1 und das zweite Material 2 stehen an ihrem anderen Ende weiters mit einer Wärmesenke 10 in thermischer Verbindung.

Das erste Material 1 ist über den elektrischen Leiter 6 mit der p-Seite 4 des pn-Übergangs 3 kontaktiert. Das zweite Material 2 ist über den elektrischen Leiter 7 mit der n-Seite 5 des pn-Übergangs 3 kontaktiert.

Am jeweils anderen Ende der Materialien 1, 2 sind eine Anode 12 bzw. eine Kathode 11 vorgesehen, über welche im dargestellten Fall der Verwendung des thermoelektrischen Elements als thermoelektrischer Generator eine Spannung abgegriffen werden kann.

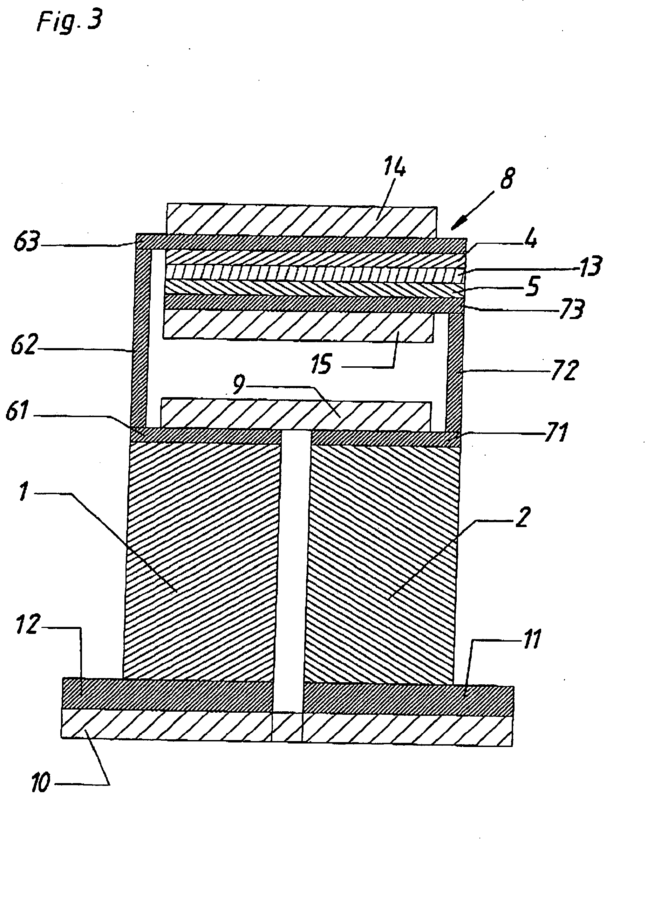

Bei dem in Fig. 3 dargestellten Ausführungsbeispiel der Erfindung ist der pn-Übergang 3 räumlich getrennt vom Thermopaar angeordnet und mit diesem nur über elektrische Leiter 61 bis 63, bzw. 71 bis 73 verbunden.

Die Diode 8 ist dabei mit gesonderten Wärmequellen 14, 15 verbunden, während das Thermopaar mit einer eigenen Wärmequelle 9 thermisch kontaktiert ist. Das Thermopaar ist weiters mit einer Wärmesenke 10 thermisch kontaktiert.

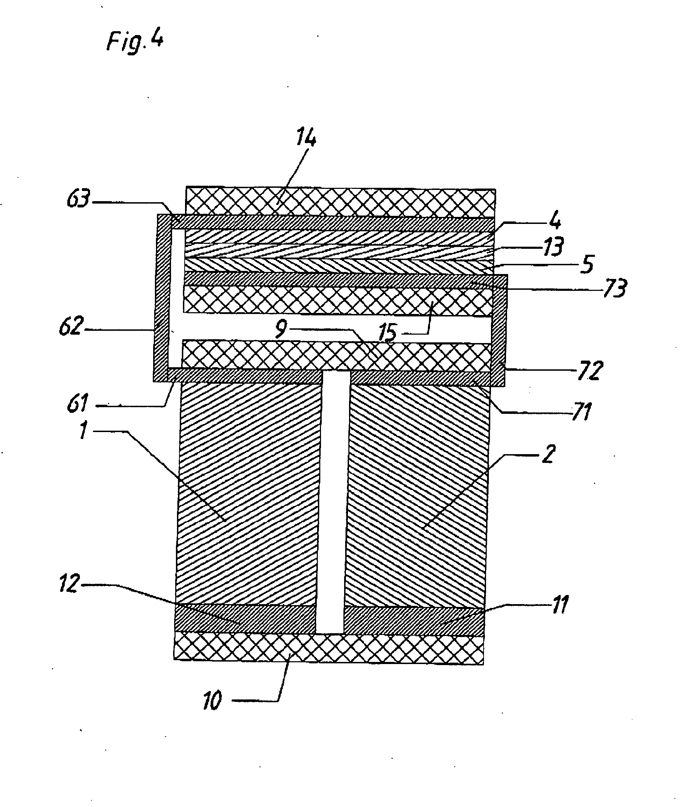

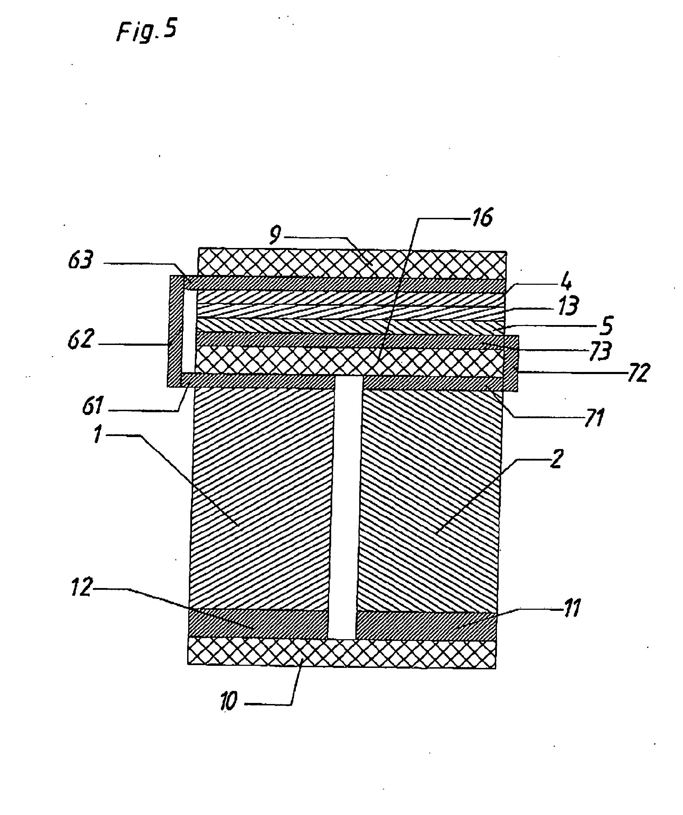

Ein ähnlich konstruiertes thermoelektrisches Element ist in der Fig. 4 dargestellt. Das in Fig. 5 dargestellte Ausführungsbeispiel unterscheidet sich von jenem der Fig. 4 darin, dass einerseits eine gemeinsame Wärmequelle 9 vorgesehen ist und andererseits aufgrund der räumlich kompakten Bauweise eine Isolierschicht 16 vorgesehen ist.

Fig. 6 zeigt einen thermoelektrischen Generator nach dem Stand der Technik, wobei das erste Material 1 und das zweite Material 2 im Bereich der Wärmequelle 9 über einen elektrischen Leiter 17 miteinander verbunden sind. Im Bereich der Wärmesenke 10 sind eine Anode 12 und eine Kathode 11 vorgesehen. Durch die Temperaturdifferenz fließt ein elektrischer Strom I.

Die Fig. 7 bis 10 zeigen weiteren Stand der Technik, nämlich einerseits eine Prinzipdarstellung eines thermoelektrischen Moduls (Fig. 7), aufgebaut aus einzelnen thermoelektrischen Elementen nach der Fig. 6. In Fig. 8 ist die Prinzipskizze eines thermoionischen Konverters dargestellt. Fig. 9 zeigt eine thermische Diode. Fig. 10 zeigt ein thermoelektrisches Element, dessen pn-Übergang 3 einen Temperaturgradianten aufweist.

In der gesamten Figurenbeschreibung bezeichnen dieselben Bezugszeichen dieselben Komponenten.

**Patentansprüche**

1. Thermoelektrischer Generator mit:

   - wenigstens einem thermoelektrischen Element, mit wenigstens einem Thermopaar und einem pn-Ütsergang (3), wobei das Thermopaar ein erstes Material (1) mit einem positiven Seebeck-Koeffizienten und ein zweites Material (2) mit einem negativen Seebeck-Koeffizienten aufweist, und wobei das erste Material (1) über einen Leiter (6) selektiv mit der p-Seite (4) des pn-Übergangs (3) kontaktiert ist und dass das zweite Material (2) über einen Leiter (7) selektiv mit der n-Seite (5) des pn-Übergangs (3) kontaktiert ist,
   - wenlgstens einer Wärmequelle (9) und
   - wenigstens einer Wärmesenke (10),

   wobei das Thermopaar des thermoetektrischen Elements zur Erzeugung einer Thermospannung mit der wenigstens einen Wärmequelle (9) und der wenigstens einen Wärmesenke (10) gekoppelt ist und wobei die Thermospannung den pn-Übergang (3) über die Leiter (6, 7) elektrisch in Sperrrichtung polt.

2. Thermoelektrischer Generator nach Anspruch 1, **dadurch gekennzeichnet, dass** das erste Material (1) ein p-dotierter Halbleiter ist.

3. Thermoelektrischer Generator nach Anspruch 1 oder 2, **dadurch gekennzeichnet, dass** das zweite Material (2) ein n-dotierter Halbleiter ist.

4. Thermoelektrischer Generator nach einem der Ansprüche 1 bis 3, **dadurch gekennzeichnet, dass** der pn-Übergang (3) in einer Diode (8) ausgebildet ist.

5. Thermoelektrischer Generator nach einem der Ansprüche 1 bis 4, **dadurch gekennzeichnet, dass** das Thermopaar und der pn-Übergang (3) aus unterschiedlichen Materialien bestehen.

6. Thermoelektrischer Generator nach einem der Ansprüche 1 bis 5, **dadurch gekennzeichnet, dass** das Thermopaar und der pn-Übergang (3) räumlich voneinander getrennt angeordnet sind.

7. Thermoelektrischer Generator nach einem der Ansprüche 1 bis 6, **dadurch gekennzeichnet, dass** das Thermopaar und der pn-Übergang (3) nur durch die Leiter (6. 7) miteinander verbunden sind.

8. Thermoelektrischer Generator nach einem der Ansprüche 1 bis 7, **dadurch gekennzeichnet, dass** der pn-Übergang (3) zur Vergrößerung der internen Fläche texturiert ausgebildet ist.

9. Thermoelektrischer Generator nach einem der Ansprüche 1 bis 8, **dadurch gekennzeichnet, dass** der pn-Übergang (3) dotiert ist.

10. Thermoelektrlscher Generator nach einem der Ansprüche 1 bis 9, **dadurch gekennzeichnet, dass** der pn-Übergang (3) Kristallfehler aufweist.

11. Thermoelektrischer Generator nach einem der Ansprüche 1 bis 10, **dadurch gekennzeichnet, dass** der Querschnitt des Thermopaars verschieden vom Querschnitt des pn-Übergangs (3) ist.

12. Thermoelektrischer Generator nach Anspruch 1, **dadurch gekennzeichnet, dass** der pn-Übergang (3) mit wenigstens einer Wärmequelle (9) gekoppelt ist.

13. Thermoelektrischer Generator nach Anspruch 12, **dadurch gekennzeichnet, dass** die Temperatur des pn-Übergangs (Tpn) verschieden von der Temperatur (Thot) der heißen Seite des Thermopaars ist.

14. Thermoelektrischer Generator nach einem der Ansprüche 1, 12 oder 13 **dadurch gekennzeichnet, dass** der pn-Übergang (3) mit wenigstens einer Wärmesenke (10) gekoppelt ist.

## Claims

1. A thermoelectric generator comprising:

   - at least one thermoelectric element comprising at least one thermocouple and a pn-junction (3), wherein the thermocouple has a first material (1) having a positive Seebeck coefficient and a second material (2) having a negative Seebeck coefficient and wherein the first material (1) is selectively contacted with the p-side (4) of the pn-junction (3) by way of a conductor (6) and the second material (2) is selectively contacted with the n-side (5) of the pn-junction (3) by way of a conductor (7),
   - at least one heat source (9), and
   - at least one heat sink (10),

   wherein the thermocouple of the thermoelectric element is coupled to the at least one heat source (9) and the at least one heat sink (10) for generating a thermoelectric voltage and wherein the thermoelectric voltage electrically poles the pn-junction (3) in the reverse direction by way of the conductors (6, 7).

2. A thermoelectric generator according to claim 1 **characterised in that** the first material (1) is a p-doped semiconductor.

3. A thermoelectric generator according to claim 1 or claim 2 **characterised in that** the second material (2) is an n-doped semiconductor.

4. A thermoelectric generator according to one of claims 1 to 3 **characterised in that** the pn-junction (3) is provided in a diode (8).

5. A thermoelectric generator according to one of claims 1 to 4 **characterised in that** the thermocouple and the pn-junction (3) consist of different materials.

6. A thermoelectric generator according to one of claims 1 to 5 **characterised in that** the thermocouple and the pn-junction (3) are arranged spatially separated from each other.

7. A thermoelectric generator according to one of claims 1 to 6 **characterised in that** the thermocouple and the pn-junction (3) are connected together only by the conductors (6, 7).

8. A thermoelectric generator according to one of claims 1 to 7 **characterised in that** the pn-junction (3) is of a textured nature to increase the internal surface area.

9. A thermoelectric generator according to one of claims 1 to 8 **characterised in that** the pn-junction (3) is doped.

10. A thermoelectric generator according to one of claims 1 to 9 **characterised in that** the pn-junction (3) has crystal defects.

11. A thermoelectric generator according to one of claims 1 to 10 **characterised in that** the cross-section of the thermocouple is different from the cross-section of the pn-junction (3).

12. A thermoelectric generator according to claim 1 **characterised in that** the pn-junction (3) is coupled to at least one heat source (9).

13. A thermoelectric generator according to claim 12 **characterised in that** the temperature of the pn-junction (Tpn) is different from the temperature (Thot) of the hot side of the thermocouple.

14. A thermoelectric generator according to one of claims 1, 12 or 13 **characterised in that** the pn-junction (3) is coupled to at least one heat sink (10).

## Revendications

1. Générateur thermoélectrique avec :

   - au moins un élément thermoélectrique, avec au moins un thermocouple et une transition pn (3), dans lequel le thermocouple présente un premier matériau (1) avec un coefficient Seebeck positif et un deuxième matériau (2) avec un coefficient Seebeck négatif, et dans lequel le premier matériau (1) est mis en contact par un conducteur (6) d'une manière sélective avec le côté p (4) de la transition pn (3) et en ce que le deuxième matériau (2) est mis en contact par un conducteur (7) d'une manière sélective avec le côté n (5) de la transition pn (3),
- au moins une source de chaleur (9) et
- au moins un dissipateur de chaleur (10),

dans lequel le thermocouple de l'élément thermoélectrique pour la production d'une tension thermoélectrique est couplé à la au moins une source de chaleur (9) et au au moins un dissipateur de chaleur (10) et dans lequel la tension thermoélectrique polarise la transition pn (3) par les conducteurs (6, 7) électriquement dans le sens d'état bloqué.

2. Générateur thermoélectrique selon la revendication 1, **caractérisé en ce que** le premier matériau (1) est un semi-conducteur dopé P.

3. Générateur thermoélectrique selon la revendication 1 ou 2, **caractérisé en ce que** le deuxième matériau (2) est un semi-conducteur dopé N.

4. Générateur thermoélectrique selon l'une des revendications 1 à 3, **caractérisé en ce que** la transition pn (3) est conçue dans une diode (8).

5. Générateur thermoélectrique selon l'une des revendications 1 à 4, **caractérisé en ce que** le thermocouple et la transition pn (3) se composent de différents matériaux.

6. Générateur thermoélectrique selon l'une des revendications 1 à 5, **caractérisé en ce que** le thermocouple et la transition pn (3) sont disposés en étant séparés l'un de l'autre dans l'espace.

7. Générateur thermoélectrique selon l'une des revendications 1 à 6, **caractérisé en ce que** le thermocouple et la transition pn (3) sont reliés ensemble uniquement par les conducteurs (6, 7).

8. Générateur thermoélectrique selon l'une des revendications 1 à 7. **caractérisé en ce que** la transition pn (3) est conçue de façon texturée pour agrandir la surface interne.

9. Générateur thermoélectrique selon l'une des revendications 1 à 8, **caractérisé en ce que** la transition pn (3) est dopée.

10. Générateur thermoélectrique selon l'une des revendications 1 à 9, **caractérisé en ce que** la transition pn (3) présente des défauts cristallins.

11. Générateur thermoélectrique selon l'une des revendications 1 à 10, **caractérisé en ce que** la section transversale du thermocouple est différente de la section transversale de la transition pn (3).

12. Générateur thermoélectrique selon la revendication 1, **caractérisé en ce que** la transition pn (3) est couplée à au moins une source de chaleur (9).

13. Générateur thermoélectrique selon la revendication 12, **caractérisé en ce que** la température de la transition pn (Tpn) est différente de la température (Thot) du côté chaud du thermocouple.

14. Générateur thermoélectrique selon l'une des revendications 1, 12 ou 13, **caractérisé en ce que** la transition pn (3) est couplée à au moins un puit de chaleur (10).

Fig.1

$T_{pn}$

$T_{HOT}$

$T_{COLD}$

Fig. 2

Fig. 3

Fig.4

Fig.5

Fig. 6

Fig. 7

*Fig.8*

*Fig.9*

Hot                                                                                          Cold

| Emitter<br>(n-type) | Barrier<br>(p-type) | Gap<br>(n-type wafer) | Collector |
|:---:|:---:|:---:|:---:|
| ~ 1 μm | ~ 1μm | ~1 mm | ~1 μm |

## Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 339715 A1
- AT 410492 B
- DE 10136667 A1
- GB 953339 A1